# DEMANDE DE BREVET EUROPEEN

(11) **EP 2 189 928 A1**
(43) Date de publication de la demande: **26.05.2010**
(21) Numéro de dépôt: 08305818.0
(22) Date de dépôt: 21.11.2008
(51) Int. Cl.: G06K 19/077, H01L 23/498

(54) **Dispositif à circuit integré muni de différents moyens de connexion**

(71) Demandeur: Gemalto SA, 92190 Meudon (FR)
(72) Inventeur: Thill, Michel, 92197 Meudon Cedex (FR); Parra, Marc, 92197 Meudon Cedex (FR); Arnal, Benoît, 92197 Meudon Cedex (FR)
(74) Mandataire: Cour, Pierre

(57) **Abrégé**

L'invention présente un dispositif à circuit intégré dont les plages de contact 11 et 12 sont dédoublées afin de permettre deux utilisations. Une première série de plages de contact 11 est destinée à être soudées sur un circuit imprimé et une deuxième série de plages de contact 12 est destinée à être utilisée pour des connexions/déconnexions multiples. Une plage de contact 11 de la première série est électriquement reliée à une plage de contact 12 de la deuxième série et à une borne de contact du circuit intégré 15.

## Description

L'invention se rapporte à un dispositif à circuit intégré muni de moyen de connexion.

Les circuits intégrés ou puces sont des circuits électroniques réalisés par gravures sur un substrat, par exemple du silicium. Une puce nue est relativement fragile et doit être manipulée dans un environnement propre. Pour être utilisé, ces circuits généralement protégés par un boitier. Le boitier est adapté à l'usage qui va être fait du circuit intégré et un boitier peut comporter une ou plusieurs puces.

Il existe des boitiers destinés à être montés sur des circuits imprimés par soudure. Ces boitiers sont facilement manipulables par des équipements industriels et sont destinés à être soudés. De très nombreux facteurs de formes sont utilisés.

Il existe des boitiers destinés à être utilisés de manière amovible. Typiquement, ce type de boitier est connu sous le nom de carte à puce (carte bancaire, carte SIM ou plug 3G) ou carte à mémoire (cartes SD, MMC, ou autre). Typiquement, ces boitiers sont manipulables à la main dans tout type d'environnement et ils disposent de plage de contact permettant de nombreuses connexions et déconnexions sans usure prématurée.

Actuellement, certains circuits intégrés très largement utilisés avec des boitiers de type carte à puce sont amenés à être utilisés dans un environnement plus industriel. A titre d'exemple, c'est le cas de carte SIM que l'on souhaite incorporer dans un équipement pour réaliser des communications de type machine-à-machine. On souhaite rendre la carte SIM solidaire de l'équipement auquel elle est rattachée tout en minimisant le coût d'industrialisation et de miniaturisation. On peut également souhaiter utiliser de la mémoire de type carte SD dans un système embarqué sans avoir besoin d'intégré un lecteur de carte.

Dans l'exemple ce rapportant à une carte SIM, une première solution est d'utiliser un lecteur de carte dans lequel on va coller la carte pour que l'on ne puisse pas la désolidariser. Une deuxième solution consiste à souder la carte SIM or les contacts de la carte SIM ne permettent pas de réaliser de bonnes soudure car les contacts extérieurs sont généralement réalisé ou recouvert d'un matériau permettant un bon contact électrique mais qui n'est pas adapté à la soudure.

Une troisième solution consiste à utiliser des circuits de carte SIM dans des boitiers plus conventionnel pour être soudé. Un autre problème survient alors, les cartes SIM sont des cartes personnalisées, c'est-à-dire individualisées par leur contenu et aussi par des marques externes visibles sur le boitier. L'industrie de la carte à puce utilise des facteurs de forme très différents des boitiers conventionnels et l'outillage n'est pas adapté pour personnaliser ce type de boitier.

En outre, il est préférable d'utiliser un même facteur de forme pour un même type de produit afin de permettre une plus grande souplesse dans la chaîne de fabrication.

L'invention résout les problèmes précédemment indiqués en utilisant un unique facteur de forme dont les plages de contact sont dédoublées afin de permettre deux utilisations de ce facteur de forme. Une première série de plages de contact est destinée à être soudées sur un circuit imprimé et une deuxième série de plages de contact est destinée à être utilisée pour des connexions/déconnexions multiples.

Plus particulièrement, l'invention est un dispositif comportant un boitier enfermant au moins un circuit intégré disposant d'une série de bornes de contact. Le boitier comprenant sur une face une première et une deuxième série de plages de contact. La première série de plages de contact a un revêtement de surface d'un premier type et la deuxième série de plages de contact a un revêtement de surface d'un deuxième type qui est différent du revêtement de surface du premier type. Une plage de contact de la première série est électriquement reliée à une plage de contact de la deuxième série et à une borne de contact du circuit intégré.

L'invention sera mieux comprise à la lecture de la description qui va suivre en se référant aux dessins annexes, parmi lesquels:
- les figures 1a et 1b montrent un premier mode de réalisation de l'invention, et
- les figures 2a et 2b montrent un deuxième mode de réalisation de l'invention.

Selon l'invention, un dispositif à puce électronique est muni de deux séries de plages de contact assurant les mêmes fonctions. Cependant chaque série de plages de contact est dédié à une utilisation particulière. Une première série de plages de contact est destinée à être soudée. Une deuxième série de plages de contact est destinée à utiliser à l'aide d'un connecteur pour une utilisation par simple contact électrique. Chaque série de plage de contact est muni d'un revêtement de surface propre à son utilisation, la première série de plages de contact ayant un revêtement de surface d'un premier type et la deuxième série de plages de contact ayant un revêtement de surface d'un deuxième type.

Ainsi, il choisi d'avoir des formes de plage de contact et des matériaux adaptés à l'utilisation. Les plages de contact de la deuxième série peuvent avoir une surface plus grande que la surface des plages de contact de la première série pour assurer une connexion par contact sur la plus grande surface possible alors que par soudure une plus petite surface est possible. Le revêtement de surface du deuxième type peut être plus conducteur que le revêtement de surface du premier type car la connexion par contact demande d'avoir une très bonne conduction au point de contact. Le revêtement de surface du deuxième type peut être plus dur que le revêtement de surface du premier type, ceci afin de limiter l'usure liée à de multiples connexions/déconnexions. Le revêtement de surface du premier type peut être plus adhérent à la soudure que le revêtement de surface du deuxième type afin d'avoir la meilleure qualité de soudure possible.

Bien entendu, il est possible de trouver des compromis sur les matériaux et il n'est pas obligatoire de respecter toutes les indications précédentes en même temps. De manière préférée, on essaie de trouver les matériaux et le forme les plus adaptées à l'usage que l'on souhaite car un compromis peut entrainer une défaillance sur l'un des usages. A titre d'exemple, le revêtement de surface du premier type est composé d'or, d'argent ou d'étain ou un alliage de nickel/palladium/or, de nickel/palladium/argent ou de nickel/étain. Toujours à titre d'exemple, le revêtement de surface du deuxième type est composé de cuivre, d'un alliage or/nickel ou de cuivre/ or/ nickel.

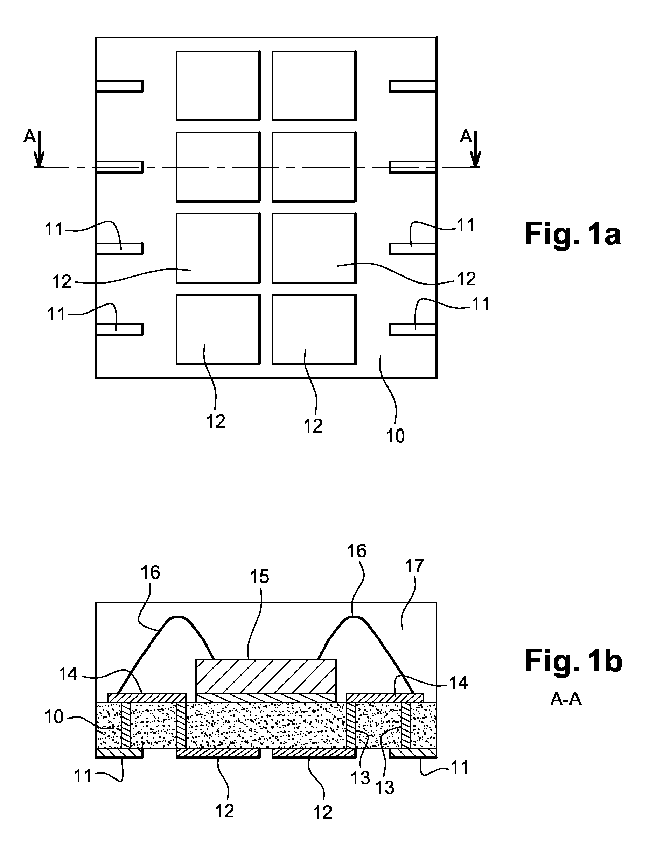

Les figures 1a et 1b illustre un premier mode de réalisation d'un dispositif selon l'invention. La figure 1b correspond au même dispositif que celui montré sur la figure 1a selon la coupe A-A, les mêmes références sont utilisées pour désigner un même élément.

Le dispositif comporte un substrat isolant 10 qui comporte sur une deuxième face des premières plages de contact 11 et des deuxièmes plages de contact 12. Ces premières et deuxièmes plages de contact 11 et 12 sont collées sur le substrat 10 et sont réalisées dans des matériaux différents. A titre d'exemple, les premières plages sont réalisées en cuivre étamé, c'est-à-dire du cuivre recouvert d'étain, et les deuxièmes plages sont réalisées en alliage de cuivre/or/nickel. Le substrat 10 est muni de trou 13 métallisé pour assurer une connexion électrique entre une première plage de contact 11 et respectivement à une deuxième plage de contact 12 par l'intermédiaire d'un conducteur métallique 14, par exemple du cuivre, collé sur la deuxième face du substrat 10.

Un circuit intégré 15 est collé sur la deuxième face du substrat 10 puis des fils de liaison 16 sont ajoutés, selon une technique connue, pour assurer la liaison électrique entre les bornes de contact du circuit intégré 15 et les conducteurs métalliques 14. Ainsi, chaque borne du circuit intégré 15 est reliée à une première plage de contact 11 et à une deuxième plage de contact 12. Un enrobage de résine est ensuite moulé par-dessus le circuit intégré 15 et sur l'intégralité de la deuxième face du substrat afin d'obtenir un boitier complet.

Comme l'aura compris l'homme du métier des variantes sont possibles. Notamment, il est possible de ne pas avoir autant de bornes de contact sur le circuit intégré qu'il y a de premières plages de contact ou de deuxièmes plages de contact. Il est également possible que certaines bornes du circuit intégré 15 puissent avoir un intérêt que dans un seul type d'utilisation de type soudé ou à connexion amovible. Il est donc possible dans le cadre de l'invention tel que défini dans les revendications d'avoir également une première plage 11 qui ne soit pas reliée à une deuxième plage 12 tout en étant reliée à une borne du circuit intégré 15. Ainsi, seule une partie des premières plages de contact 11 peut être reliée à une partie des deuxièmes plages de contact et à des bornes du circuit intégré 15.

Ce premier mode de réalisation est particulièrement bien adapté pour les cartes à mémoire car celles-ci disposent d'une certaine place sur le boitier à coté des contacts électrique dont elles disposent. En outre le fait d'avoir des premières et deuxièmes plages de contact 11 et 12 n'ayant pas de contact direct mais un contact rapporté par les conducteurs 14 à travers la couche isolante constituée par le substrat 10 permet d'éviter un pont thermique entre les deux matériaux qui peut, dans certains cas, dégrader les conditions de soudure.

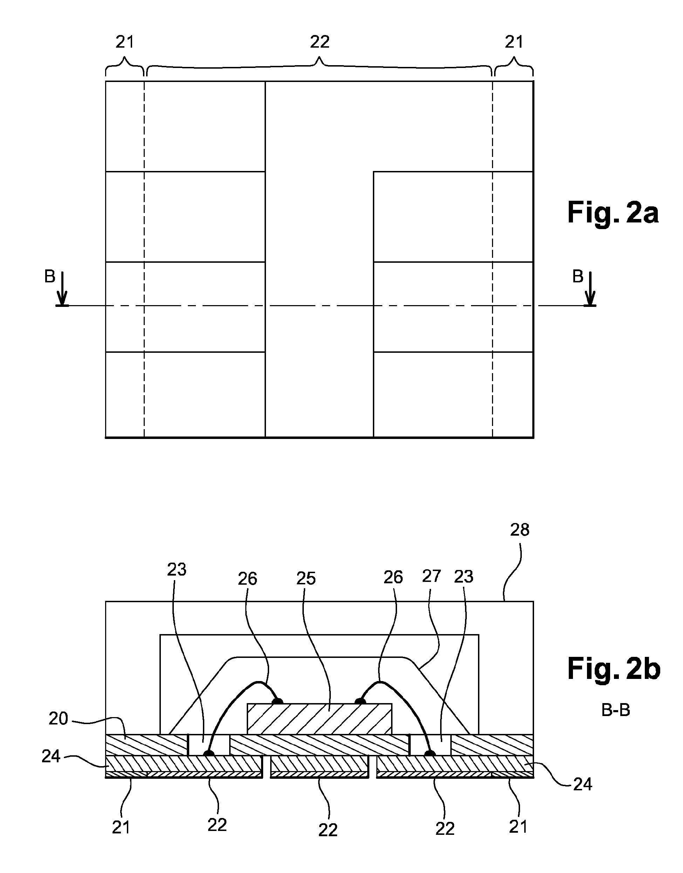

Si l'on souhaite par contre rester dans un facteur de forme proche des cartes à puce pour des raisons de compatibilité avec les standards existants, il convient de regarder le deuxième mode de réalisation basé sur un connecteur conforme à la norme ISO 7816. Les cartes SIM peuvent être au format carte de crédit et comprendre une partie détachable qui peut être réduite à la taille du connecteur, ce format est connu sous le nom de « plug 3G ». Les figures 2a et 2b montrent un plug 3G réalisé conformément à l'invention.

La figure 2a montre un connecteur de carte à puce qui peut apparaître conventionnel. Cependant, comme le sait l'homme du métier, les contacts définis pour une carte selon la norme ISO 7816 sont plus réduit que ce la taille du connecteur. Ainsi, selon l'invention, chaque contact du connecteur est séparé en deux plages de contact.

Comme connu, un substrat 20 isolant comporte sur une première face des conducteurs 24, par exemple en cuivre qui forment le connecteur tel que connu de la technique. Cependant, ce connecteur va subir un premier plaquage dans un premier matériau sur sa partie extérieure pour former des premières plages de contact 21 et un deuxième plaquage dans un deuxième matériau pour former des deuxièmes plages de contact 22. Les deuxièmes plages de contact 22 sont, en outre, conformes au standard ISO 7816. A titre d'exemple, ces plaquages sont réalisés par masquage d'une partie du connecteur puis dépôt par électrolyse du plaquage souhaité. Avec un tel mode de réalisation, chaque première plage de contact 21 est électriquement reliée à l'une des deuxièmes plages de contact 22 par le conducteur 24 sur lequel le plaquage est réalisé.

Un circuit intégré 25 est collée sur la deuxième face du substrat 20. Des fils de liaison 26 sont ajoutés pour établir le contact électrique entre les bornes du circuit intégré 25 et les conducteur 24 au travers de trous 23 réalisés dans le substrat 20. Une résine 27 est ensuite déposée sur la puce 25 et les fils de liaison pour former un module de carte à puce. Le module ainsi formé est alors collé dans un corps 28 de carte à puce préalablement usiné.

L'homme du métier peut transposer ce mode de réalisation avec toutes les techniques de réalisation de carte à puce. Notamment, une couche métallique peut être présente sur la deuxième face et communiquer avec les conducteurs 24. Plusieurs puces peuvent être connectées ensemble. Tous les conducteurs 24 ne sont pas nécessairement utilisés et donc connecté à la puce 25. La puce peut être montée en « flip-chip », c'est-à-dire retournée et soudée sur une couche métallique. Différentes technique d'enrobage de puce peuvent être utilisées.

De plus, dans l'exemple décrit, deux plaquages sont réalisés alors qu'il est possible de faire un seul plaquage si le matériau correspondant aux conducteurs 24 permet en lui-même d'assurer la fonction des premières plages 21 ou des deuxièmes plages 22. Dans le cas où deux plaquages sont réalisés, il est possible de ne faire l'opération de masquage avant électrolyse qu'une seule fois : un premier plaquage est réalisé puis l'on masque les plages correspondant à ce plaquage et on effectue le deuxième plaquage.

L'homme du métier remarquera que le deuxième mode de réalisation permet de faire des cartes SIM selon l'invention qui sont utilisables dans tout les téléphone actuels tout en permettant de les souder directement sur des cartes imprimées avec une bonne qualité de soudure.

## Revendications

1. Dispositif comportant un boitier enfermant au moins un circuit intégré (15, 25) disposant d'une série de bornes de contact, le boitier comprenant sur une face :
- une première série de plages de contact (11, 2 1), lesdites plages de contact (11, 21) ayant un revêtement de surface d'un premier type,
- une deuxième série de plages de contact (12, 22), lesdites plages de contact (12, 22) ayant un revêtement de surface d'un deuxième type qui est différent du revêtement de surface du premier type,
dans lequel une plage de contact (11, 21) de la première série est électriquement reliée à une plage de contact (12, 22) de la deuxième série et à une borne de contact du circuit intégré (15, 25).

2. Dispositif selon la revendication 1, dans lequel le revêtement de surface du premier type est destiné à être soudé et le revêtement de surface du deuxième type est destiné à assurer un contact électrique par simple contact.

3. Dispositif selon la revendication 1, dans lequel les plages de contact (12, 22) de la deuxième série ont une surface plus grande que la surface des plages de contact (11, 21) de la première série.

4. Dispositif selon la revendication 1, dans lequel le revêtement de surface du deuxième type est plus conducteur que le revêtement de surface du premier type.

5. Dispositif selon la revendication 1, dans lequel le revêtement de surface du deuxième type est plus dur que le revêtement de surface du premier type.

6. Dispositif selon la revendication 1, dans lequel le revêtement de surface du premier type est plus adhérent à la soudure que le revêtement de surface du deuxième type.

7. Dispositif selon la revendication 1, dans lequel le revêtement de surface du premier type est composé d'un matériau choisi parmi :
- l'or,
- l'argent,
- l'étain,
- un alliage de nickel/palladium/or,
- un alliage de nickel/palladium/argent,
- ou de nickel/étain.

8. Dispositif selon la revendication 1, dans lequel le revêtement de surface du deuxième type est composé d'un matériau choisi parmi :
- le cuivre,
- un alliage or/nickel,
- un alliage de cuivre/ or/ nickel.

9. Dispositif selon la revendication 1 dans lequel la deuxième série de plages de contact (22) est disposée en conformité avec la norme ISO 7816.

10. Dispositif selon la revendication 1, dans lequel les plages de contact (21, 22) des première et deuxième séries sont réalisées sur un même conducteur (24) et dans lequel les premier et deuxième types de revêtement se distinguent par au moins un plaquage de matériaux différents

11. Dispositif selon la revendication 1, dans lequel les plages de contact (11, 12) des première et deuxième séries sont en contact électrique par l'intermédiaire d'un conducteur (14) séparé des dites plages de contact (11, 12) par au moins une couche isolante (10) muni de trous métallisés (13).
